# EUROPEAN PATENT APPLICATION

(11) **EP 4 539 131 A1**
(43) Date of publication of application: **16.04.2025**
(21) Application number: 23824072.5
(22) Date of filing: 21.04.2023
(51) Int. Cl.: H01L 31/18, H01L 31/048, H01L 31/05

(54) **SOLAR CELL AND MANUFACTURING METHOD THEREOF**

(30) Priority: 13.06.2022 KR 20220071332
(71) Applicant: Mecaroenergy Co., Ltd., Chungcheongbuk-do 27721 (KR)
(72) Inventor: LEE, Gyu Hyun, Chungju-si, Chungcheongbuk-do 27480 (KR); KIM, Jun Yeop, Eumseong-gun, Chungcheongbuk-do 27649 (KR); KIM, Deok Reol, Jincheon-gun, Chungcheongbuk-do 27872 (KR)
(74) Representative: Casalonga
(86) International application number: PCT/KR2023/005453
(87) International publication number: WO 2023/243846

(57) **Abstract**

The present invention relates to a solar cell and a method of manufacturing the same. The method of manufacturing the solar cell, according to the present invention, includes: a first step of forming a lower transparent resin layer on a lower cover glass; a second step of disposing a plurality of thin-film solar cells and a plurality of glass blocks on the lower transparent resin layer; a third step of forming an upper transparent resin layer on top of the plurality of thin-film solar cells and the plurality of glass blocks; and a fourth step of disposing an upper cover glass on the upper transparent resin layer to configure the solar cell, wherein, in the second step, the plurality of glass blocks are each disposed between the plurality of thin-film solar cells on the lower transparent resin layer.

## Description

### [Technical Field]

The present invention relates to a solar cell and a method of manufacturing the same, and more particularly, to a transparent solar cell with enhanced light transmission functionality while simultaneously generating electricity of a solar cell.

### [Background Art]

Due to issues such as global environmental concerns, depletion of fossil energy, waste disposal from nuclear power generation, and site selection for new power plant construction, interest in renewable energy is on the rise. In this regard, interest in solar cells, which are environmentally friendly and provide sustainable clean energy, is continuously growing.

Additionally, based on recent environmental issues and carbon neutrality policies, etc., the solar cell market is expected to grow steadily, and with the acceleration of global efforts to address the climate crisis, such as the mandatory implementation of zero-energy buildings, the BIPV market is anticipated to be a key market of focus. Along with this, the demand for transparent solar cells is expected to increase day by day.

Currently, research on transparent solar cells applying thin-film solar cells is actively being conducted. However, solar cells with a transmittance of 50 % or more show an energy conversion efficiency of only a level of 5 %.

Therefore, the demand for solar cells with high transmittance and excellent energy conversion efficiency, as well as manufacturing methods thereof, is increasing.

### [Disclosure]

### [Technical Problem]

The present invention has been made in an effort to solve the aforementioned problems, and an object of the present invention is to provide a solar cell with excellent visibility and a method of manufacturing the same by using a thin-film solar cell deposited on a glass substrate and a sealing member with a similar refractive index.

In addition, the present invention is directed to providing a solar cell and a method of manufacturing the same with minimized image distortion, high transmittance, and excellent energy conversion efficiency.

### [Technical Solution]

To solve the aforementioned problems, there is provided a method of manufacturing a solar cell, according an embodiment of the present invention. The method may include: a first step of forming a lower transparent resin layer on a lower cover glass; a second step of disposing a plurality of thin-film solar cells and a plurality of glass blocks on the lower transparent resin layer; a third step of forming an upper transparent resin layer on top of the plurality of thin-film solar cells and the plurality of glass blocks; and a fourth step of disposing an upper cover glass on the upper transparent resin layer to configure the solar cell, in which, in the second step, the plurality of glass blocks are each disposed between the plurality of thin-film solar cells on the lower transparent resin layer.

According to another embodiment of the present invention, the second step may further include additionally inserting a transparent resin between the glass block and the thin-film solar cell.

According to another embodiment of the present invention, the lower cover glass or the upper cover glass may have an uneven structure formed on a surface thereof.

According to another embodiment of the present invention, the thin-film solar cell may be configured for electrodes with a conductive tape structure to be bonded at both ends, or for electrodes to be bonded by ultrasonic bonding or thermal bonding.

According to another embodiment of the present invention, in the second step, electrodes at both ends of the aligned thin-film solar cells may be mutually connected in parallel or in series.

According to another embodiment of the present invention, the second step may further include fixing the lower cover glass, on which the plurality of thin-film solar cells and the plurality of glass blocks are disposed, using high-temperature tape, a fixing housing, or brackets.

According to another embodiment of the present invention, the thin-film solar cell may be composed of a copper indium gallium selenide (CIGS) thin film solar cell, a perovskite solar cell, or a perovskite-CIGS tandem solar cell.

According to another embodiment of the present invention, the method may further include: a fifth step in which the solar cell undergoes vacuum heat treatment, whereby the lower cover glass, the thin-film solar cell, the glass block, and the upper cover glass are bonded together by the lower transparent resin layer, the upper transparent resin layer, and the transparent resin.

In addition, there is provided a solar cell, according to an embodiment of the present invention. The solar cell may be configured to include: a lower cover glass; a lower transparent resin layer formed on the lower cover glass; a plurality of thin-film solar cells disposed on the lower transparent resin layer; a plurality of glass blocks, each disposed between the plurality of thin-film solar cells on the lower transparent resin layer; an upper transparent resin layer formed on top of the plurality of thin-film solar cells and the plurality of glass blocks; and an upper cover glass disposed on the upper transparent resin layer.

### [Advantageous Effects]

According to the present invention, by using a thin-film solar cell deposited on a glass substrate and a sealing member with a similar refractive index, a solar cell with excellent visibility and a method of manufacturing the same can be provided.

In addition, according to the present invention, a solar cell and a method of manufacturing the same can be provided with minimized image distortion, high transmittance, and excellent energy conversion efficiency.

### [Description of Drawings]

FIG. 1 is an exploded perspective view of a solar cell according to an embodiment of the present invention.
FIG. 2 is a side view of a solar cell according to an embodiment of the present invention.
FIG. 3 is a top plan view of a solar cell according to an embodiment of the present invention.
FIG. 4 is a flowchart for describing a method of manufacturing a solar cell according to an embodiment of the present invention.
FIG. 5 is a view for describing a method of fixing a solar cell according to an embodiment of the present invention.
FIG. 6 is a view illustrating a solar cell according to an embodiment of the present invention.
FIG. 7 is a view illustrating an image distortion phenomenon occurring in a solar cell according to the related art.
FIG. 8 is a view illustrating improved visibility of a solar cell according to an embodiment of the present invention.

### [Mode for Disclosure]

The present invention may be variously modified and may have various exemplary embodiments, and particular exemplary embodiments illustrated in the drawings will be described in detail below. However, the description of the exemplary embodiments is not intended to limit the present invention to the particular exemplary embodiments, but it should be understood that the present invention is to cover all modifications, equivalents and alternatives falling within the spirit and technical scope of the present invention.

However, in the description of the embodiments, the specific descriptions of related well-known functions or configurations will be omitted when it is determined that the specific descriptions may unnecessarily obscure the subject matter of the present invention. In addition, for the sake of description, the sizes of individual constituent elements in the appended drawings may be exaggeratingly depicted and do not indicate the actual sizes for the applications.

In addition, throughout the specification, when one constituent element is referred to as being "connected" or "accessed" to another constituent element, it may be understood that the one constituent element is either directly connected or directly accessed to the other constituent element. However, unless specifically stated otherwise, it should be understood that the one constituent element may also be connected or accessed via another constituent element in between. In addition, throughout the present specification, unless explicitly described to the contrary, the word "comprise/include" and variations such as "comprises/includes" or "comprising/including" will be understood to imply the inclusion of stated elements, not the exclusion of any other elements.

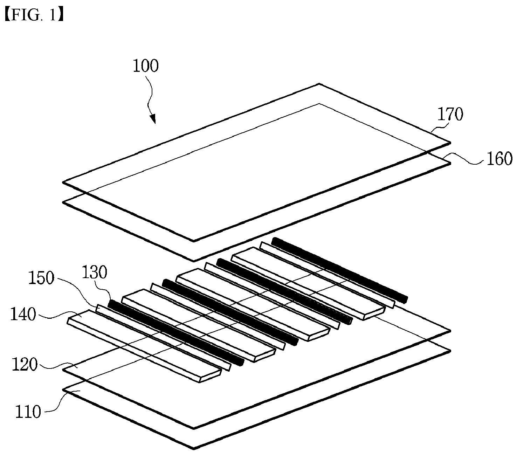

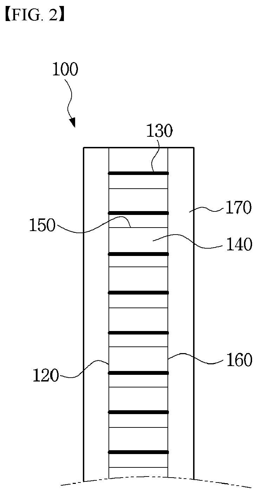

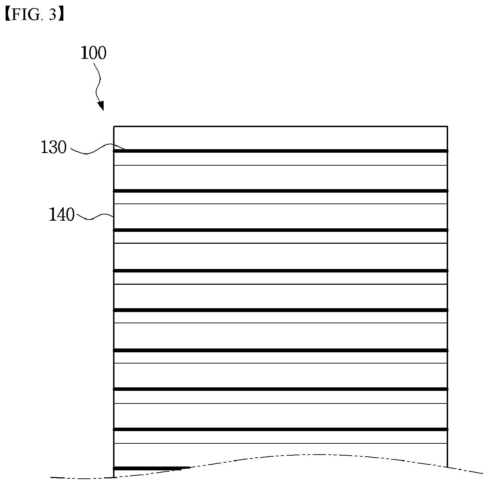

FIG. 1 is an exploded perspective view of a solar cell according to an embodiment of the present invention, FIG. 2 is a side view of a solar cell according to an embodiment of the present invention, and FIG. 3 is a top plan view of a solar cell according to an embodiment of the present invention.

Hereinafter, with reference to FIGS. 1 to 3, the configuration of a solar cell according to an embodiment of the present invention will be described.

A solar cell according to an embodiment of the present invention may be configured to include a lower cover glass 110, a lower transparent resin layer 120, a thin-film solar cell 130, a glass block 140, transparent resin 150, an upper transparent resin layer 160, and an upper cover glass 170.

The lower transparent resin layer 120 is formed on the lower cover glass 110.

In this case, the lower transparent resin layer 120 may be composed of a photo-curable resin or a thermosetting resin. More specifically, the lower transparent resin layer 120 may be composed of ethylene vinyl acetate (EVA) and configured to adhere the thin-film solar cell 130 and the glass block 140 to the lower cover glass 110. The lower transparent resin layer 120 may be disposed on the lower cover glass 110 with a thickness of 0.1 to 1 mm.

In this case, the lower cover glass 110 may be tempered glass and may be configured to further include an anti-reflective film.

In addition, the lower cover glass 110 may have an uneven structure formed on a surface bonded to the lower transparent resin layer 120 to minimize light reflection. Meanwhile, a thickness of the lower cover glass 110 may be configured to be 0.5 to 10 mm.

A plurality of thin-film solar cells 130 are disposed on the lower transparent resin layer 120.

In this case, the thin-film solar cell 130 may be configured for electrodes with a conductive tape structure to be bonded at both ends, or for electrodes to be bonded by ultrasonic bonding or thermal bonding. The electrodes at both ends of the aligned thin-film solar cells 130 may be mutually connected in parallel or in series.

In addition, the thin-film solar cell 130 may be composed of a copper indium gallium selenide (CIGS) thin film solar cell, a perovskite solar cell, or a perovskite-CIGS tandem solar cell.

Furthermore, the thin-film solar cells 130 according to an embodiment of the present invention may be mutually connected in series or parallel, and to connect the electrodes, electrode ribbons may be bonded to both ends of a monolithic-structured thin-film solar cell 130. The bonding methods may include methods such as bonding using a conductive tape, ultrasonic bonding, or thermal bonding. In addition, a portion of the thin film may be removed to allow contact with the electrode in order to minimize contact resistance during bonding.

In this case, to prevent bonding defects and bubbles caused by step differences during bonding with the upper cover glass 170, the step difference at an electrode connection site may be minimized and configured to be thinner than a thickness of the EVA (lower transparent resin layer 120, transparent resin 150, and upper transparent resin layer 160).

Meanwhile, a plurality of glass blocks 140 are each disposed between a plurality of thin-film solar cells 130 on the lower transparent resin layer 120.

In this case, the glass block 140 may be formed to have the same height as the thin-film solar cell 130.

Further, to interface bond between the thin-film solar cell 130 and the glass block 140, transparent resin 150 made of EVA material may be additionally inserted therebetween.

In addition, a width of the glass block 140 may be configured to be 10 to 50 mm, and a height thereof may be 5 to 20 mm, which may be adjusted to match the aperture ratio and the capacity of the thin-film solar cell 130.

Meanwhile, the glass block 140 may use the same material as the lower cover glass 110 and the upper cover glass 170 in order to minimize refractive index differences and any sense of heterogeneity.

The upper transparent resin layer 160 is formed on top of the plurality of thin-film solar cells 130 and the plurality of glass blocks 140, and the upper cover glass 170 is disposed on the upper transparent resin layer 160.

That is, to protect the fixed module and ensure smooth bonding with the glass block, the upper transparent resin layer 160 made of EVA material is additionally disposed on top, and then the upper cover glass 170 is disposed to cover the upper transparent resin layer 160.

In this case, the upper transparent resin layer 160 may be composed of ethylene vinyl acetate (EVA) and configured to adhere the thin-film solar cell 130 and the glass block 140 to the lower cover glass 110. The upper transparent resin layer 160 may have a thickness of 0.1 to 1 mm.

In addition, the upper cover glass 170 may be configured in the same way as the lower cover glass 110.

More specifically, the upper cover glass 170 may have an uneven structure formed on the surface bonded to the upper transparent resin layer 160 to minimize light reflection, and a thickness of the upper cover glass 170 may be configured to be 0.5 to 10 mm.

As described above, the solar cell with the upper cover glass 170 disposed on the upper transparent resin layer 160 is completely bonded through a vacuum heat treatment process.

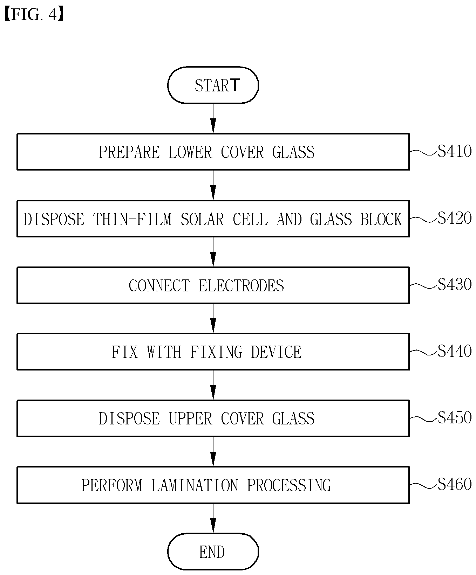

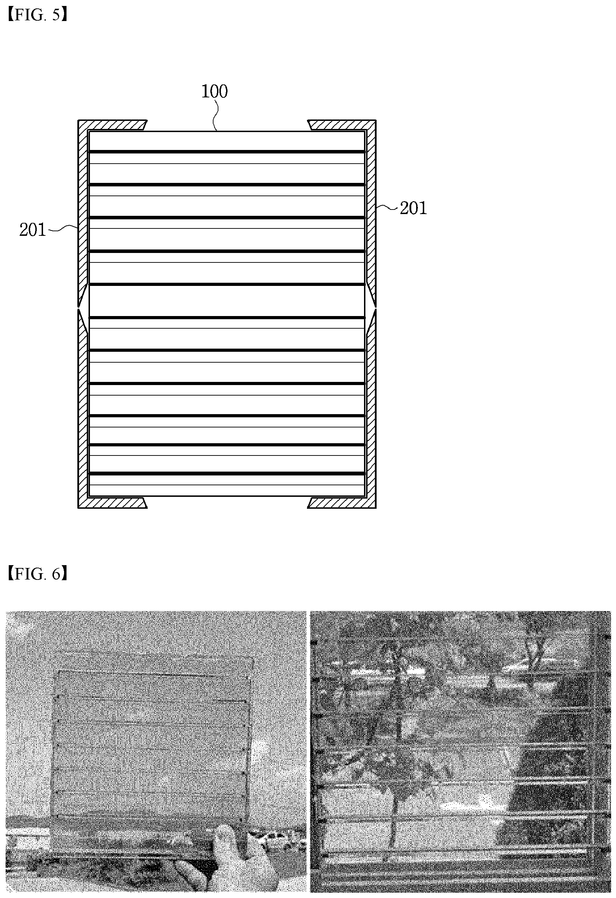

FIG. 4 is a flowchart for describing a method of manufacturing a solar cell according to an embodiment of the present invention, and FIG. 5 is a view for describing a method of fixing a solar cell according to an embodiment of the present invention.

Hereinafter, with reference to FIGS. 4 and 5, a method of manufacturing a solar cell according to an embodiment of the present invention will be described.

First, the lower transparent resin layer 120 is formed on the lower cover glass 110 (S410).

In this case, the lower transparent resin layer 120 may be composed of ethylene vinyl acetate (EVA) and configured to adhere the thin-film solar cell 130 and the glass block 140 to the lower cover glass 110. The lower transparent resin layer 120 may be disposed on the lower cover glass 110 with a thickness of 0.1 to 1 mm.

In this case, the lower cover glass 110 may be tempered glass and may be configured to further include an anti-reflective film.

In addition, the lower cover glass 110 may have an uneven structure formed on a surface bonded to the lower transparent resin layer 120 to minimize light reflection. Meanwhile, a thickness of the lower cover glass 110 may be configured to be 0.5 to 10 mm.

Then, the plurality of thin-film solar cells 130 and the plurality of glass blocks 140 are disposed on the lower transparent resin layer 120 (S420).

In this case, the thin-film solar cell 130 may be configured for electrodes with a conductive tape structure to be bonded at both ends, or for electrodes to be bonded by ultrasonic bonding or thermal bonding. The electrodes at both ends of the aligned thin-film solar cells 130 may be mutually connected in parallel or in series.

In addition, the thin-film solar cell 130 may be composed of a copper indium gallium selenide (CIGS) thin film solar cell, a perovskite solar cell, or a perovskite-CIGS tandem solar cell.

Meanwhile, the thin-film solar cell 130 and the glass block 140 may be sequentially disposed on the disposed lower transparent resin layer 120. In this case, to interface bond between the thin-film solar cell 130 and the glass block 140, transparent resin 150 made of EVA material may be additionally inserted therebetween.

In addition, a width of the glass block 140 may be configured to be 10 to 50 mm, and a height thereof may be 5 to 20 mm, which may be adjusted to match the aperture ratio and the capacity of the thin-film solar cell 130.

In this case, the glass block 140 may use the same material as the lower cover glass 110 and the upper cover glass 170 in order to minimize refractive index differences and any sense of heterogeneity.

Next, the electrodes of the thin-film solar cell 130 are connected (S430).

That is, to connect the electrodes of the thin-film solar cell 130, electrode ribbons may be bonded to both ends of the monolithic-structured thin-film solar cell 130. The bonding methods may include methods such as bonding using a conductive tape, ultrasonic bonding, or thermal bonding. In addition, a portion of the thin film may be removed to allow contact with the electrode in order to minimize contact resistance during bonding.

In this case, to prevent bonding defects and bubbles caused by step differences during bonding with the upper cover glass 170, the step difference at an electrode connection site may be minimized and configured to be thinner than a thickness of the EVA (lower transparent resin layer 120, transparent resin 150, and upper transparent resin layer 160).

Then, the lower cover glass 110, on which the thin-film solar cell 130 and the glass block 140 are disposed, may be fixed using high-temperature tape, a fixing housing, or brackets (S440).

That is, as illustrated in FIG. 5, to prevent deformation or other issues that may occur during the working process of the solar cell 100, the lower cover glass 110 may be fixed using fixing means 201 such as high-temperature tape, a fixing housing, or brackets.

Next, the upper transparent resin layer 160 is formed on top of the plurality of thin-film solar cells 130 and the plurality of glass blocks 140, and the upper cover glass 170 is disposed on the upper transparent resin layer 160 to configure the solar cell (S450).

That is, to protect the fixed module and ensure smooth bonding with the glass block, the upper transparent resin layer 160 made of EVA material is additionally disposed on top, and then allowing the upper cover glass 170 to cover the upper transparent resin layer 160.

In this case, the upper transparent resin layer 160 may be composed of ethylene vinyl acetate (EVA) and configured to adhere the thin-film solar cell 130 and the glass block 140 to the lower cover glass 110. The upper transparent resin layer 160 may have a thickness of 0.1 to 1 mm.

In addition, the upper cover glass 170 may be configured in the same way as the lower cover glass 110.

More specifically, the upper cover glass 170 may have an uneven structure formed on the surface bonded to the upper transparent resin layer 160 to minimize light reflection, and a thickness of the upper cover glass 170 may be configured to be 0.5 to 10 mm.

Next, lamination processing is performed (S460).

More specifically, the solar cell undergoes vacuum heat treatment, whereby the lower cover glass 110, the thin-film solar cell 130, the glass block 140, and the upper cover glass 170 are bonded together by the lower transparent resin layer 120, the upper transparent resin layer 160, and the transparent resin 150.

That is, a vacuum heat treatment process may be performed using EVA so that the lower cover glass 110, the thin-film solar cell 130, the glass block 140, and the upper cover glass 170 are perfectly bonded. In this case, the vacuum heat treatment may be conducted at a temperature of 50 to 200 °C, more specifically, with 150 °C being the optimal vacuum heat treatment temperature.

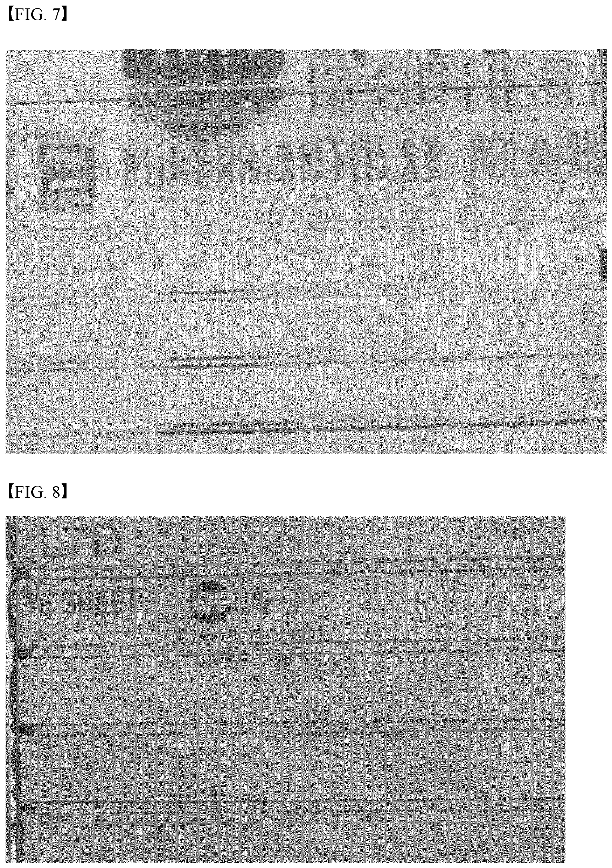

FIG. 6 is a view illustrating a solar cell according to an embodiment of the present invention, FIG. 7 is a view illustrating an image distortion phenomenon occurring in a solar cell according to the related art, and FIG. 8 is a view illustrating visibility of a solar cell according to an embodiment of the present invention.

As illustrated in FIG. 6, it can be confirmed that the solar cell according to an embodiment of the present invention has excellent visibility.

In addition, as illustrated in FIG. 7, the solar cell according to the related art exhibits an image distortion phenomenon due to light distortion. In contrast, as illustrated in FIG. 8, it can be confirmed that the solar cell according to the present invention, which uses a thin-film solar cell deposited on a glass substrate and a sealing member with a similar refractive index, has excellent visibility.

The detailed description of the present invention as described above has described specific embodiments. However, various modifications are possible without departing from the scope of the present invention. The technical spirit of the present invention should not be limited to the aforementioned embodiments but should be defined by not only the claims to be described below, but also those equivalent to the claims.

## Claims

1. A method of manufacturing a solar cell, comprising:
a first step of forming a lower transparent resin layer on a lower cover glass;
a second step of disposing a plurality of thin-film solar cells and a plurality of glass blocks on the lower transparent resin layer;
a third step of forming an upper transparent resin layer on top of the plurality of thin-film solar cells and the plurality of glass blocks; and
a fourth step of disposing an upper cover glass on the upper transparent resin layer to configure the solar cell,
wherein, in the second step, the plurality of glass blocks are each disposed between the plurality of thin-film solar cells on the lower transparent resin layer.

2. The method of claim 1, wherein the second step further includes additionally inserting a transparent resin between the glass block and the thin-film solar cell.

3. The method of claim 1, wherein the lower cover glass or the upper cover glass has an uneven structure formed on a surface thereof.

4. The method of claim 1, wherein the thin-film solar cell is configured for electrodes with a conductive tape structure to be bonded at both ends, or for electrodes to be bonded by ultrasonic bonding or thermal bonding.

5. The method of claim 4, wherein in the second step, electrodes at both ends of the aligned thin-film solar cells are mutually connected in parallel or in series.

6. The method of claim 1, wherein the second step further includes fixing the lower cover glass, on which the plurality of thin-film solar cells and the plurality of glass blocks are disposed, using high-temperature tape, a fixing housing, or brackets.

7. The method of claim 1, wherein the thin-film solar cell is composed of a copper indium gallium selenide (CIGS) thin film solar cell, a perovskite solar cell, or a perovskite-CIGS tandem solar cell.

8. The method of claim 2, further comprising:
a fifth step in which the solar cell undergoes vacuum heat treatment, whereby the lower cover glass, the thin-film solar cell, the glass block, and the upper cover glass are bonded together by the lower transparent resin layer, the upper transparent resin layer, and the transparent resin.

9. A solar cell comprising:
a lower cover glass;
a lower transparent resin layer formed on the lower cover glass;
a plurality of thin-film solar cells disposed on the lower transparent resin layer;
a plurality of glass blocks, each disposed between the plurality of thin-film solar cells on the lower transparent resin layer;
an upper transparent resin layer formed on top of the plurality of thin-film solar cells and the plurality of glass blocks; and
an upper cover glass disposed on the upper transparent resin layer.

10. The solar cell of claim 9, wherein the lower cover glass or the upper cover glass has an uneven structure formed on a surface thereof.

11. The solar cell of claim 9, wherein the lower transparent resin layer and the upper transparent resin layer are composed of a photo-curable resin or a thermosetting resin.

12. The solar cell of claim 9, wherein the thin-film solar cell is configured for electrodes with a conductive tape structure to be bonded at both ends, or for electrodes to be bonded by ultrasonic bonding or thermal bonding, such that the electrodes at both ends of the aligned thin-film solar cells are mutually connected in parallel or in series.

13. The solar cell of claim 9, wherein the thin-film solar cell is composed of a copper indium gallium selenide (CIGS) thin film solar cell, a perovskite solar cell, or a perovskite-CIGS tandem solar cell.
